# EUROPEAN PATENT APPLICATION

(11) **EP 4 752 565 A2**
(43) Date of publication of application: **03.06.2026**
(21) Application number: 25211556.3
(22) Date of filing: 28.10.2025
(51) Int. Cl.: G01R 1/20

(54) **DEVICE FOR MEASURING VOLTAGE**

(30) Priority: 06.11.2024 KR 20240156571
(71) Applicant: SAMSUNG SDI CO., LTD., Yongin-si, Gyeonggi-do 17084 (KR)
(72) Inventor: YOO, Junho, 17084 Yongin-Si, Gyeonggi-do (KR); JEONG, Hyeoncheol, 17084 Yongin-Si, Gyeonggi-do (KR); YOON, Seokbin, 17084 Yongin-Si, Gyeonggi-do (KR)
(74) Representative: Gulde & Partner

(57) **Abstract**

A voltage measurement device may include a busbar electrically connected to a first terminal and a second terminal that are electrically connected to a battery cell, with the busbar extending in a first direction. A shunt resistance may be positioned on the busbar and extend in a second direction that intersects the first direction. A measurement unit is configured to measure a first voltage value applied to a first sub-region of the shunt resistance and measure a second voltage value applied to a second sub-region of the shunt resistance.

## Description

### BACKGROUND

### 1. Field

The present disclosure relates to a voltage measurement device for measuring voltages in multiple sub-regions of a shunt resistance.

### 2. Description of the Related Art

Unlike primary batteries that are not designed to be (re)charged, secondary (or rechargeable) batteries can be discharged and recharged. Low-capacity secondary batteries are used in portable, small electronic devices, such as smart phones, feature phones, notebook computers, digital cameras, and camcorders. Large-capacity secondary batteries are widely used as power sources for driving motors in hybrid vehicles and electric vehicles and for storing power (e.g., home and/or utility scale power storage). A secondary battery generally includes an electrode assembly comprising a positive electrode and a negative electrode, a case accommodating the electrodes, and electrode terminals connected to the electrode assembly.

When a rechargeable battery such as a lithium-ion battery is repeatedly charged and discharged, a lifespan of the battery may be reduced or performance of the battery may deteriorate. Because of this and other reasons, a battery management system (BMS) may be installed in an electric vehicle, an energy storage system, and the like to periodically monitor a status of the battery. In general, the battery management system may be configured to monitor a voltage, current, temperature, and the like of the battery and manage the charging and discharging of the battery.

The battery management system may measure a voltage of a shunt resistance disposed in a partial section connected to the battery cell. Problems may occur in the shunt resistance due to continuous use of apparatuses or systems connected to the battery cell or a surrounding environment. However, the battery management system may not recognize the problems occurring in the shunt resistance, and the battery management system may not have a configuration that detects the problems occurring in the shunt resistance.

The information disclosed in this section is for enhancement of understanding of the background of the present disclosure. It may contain information that does not constitute related or prior art.

### SUMMARY

The present disclosure provides a voltage measurement device for addressing the above-described problems. However, the present disclosure is not limited to solving such problems.

Aspects and features of the present disclosure will be described in or will be apparent from the following description of embodiments of the present disclosure.

According to some embodiments of the present disclosure, a voltage measurement device includes a busbar electrically connected to a first terminal and a second terminal that are electrically connected to a battery cell, the busbar extending in a first direction, a shunt resistance positioned on the busbar and extending in a second direction that intersects the first direction, and a measurement device configured to measure a first voltage value applied to a first sub-region of the shunt resistance and measures a second voltage value applied to a second sub-region of the shunt resistance.

According to some embodiments of the present disclosure, the voltage measurement device may include a first sensor and a second sensor positioned at opposite ends of the first sub-region, each of the first and second sensors having a measurement terminal disposed thereon for measuring voltages by the measurement device, and a third sensor and a fourth sensor positioned at opposite ends of the second sub-region, each of the third and fourth sensors having a measurement terminal disposed thereon for measuring voltages by the measurement device.

According to some embodiments of the present disclosure, the measurement device may measure (or be configured to measure) a third voltage value applied between the first sensor and the fourth sensor, and may measure (or be configured to measure) a fourth voltage value applied between the third sensor and the second sensor.

According to some embodiments of the present disclosure, the first sensor and the third sensor may be disposed (or arranged) adjacent to a first side of the shunt resistance, and the second sensor and the fourth sensor may be disposed (or arranged) adjacent to a second side of the shunt resistance.

According to some embodiments of the present disclosure, the first sensor may be disposed or arranged symmetric to the second sensing unit with respect to a center line of the shunt resistance, and the third sensor may be disposed or arranged symmetric to the fourth sensing unit with respect to the center line of the shunt resistance.

According to some embodiments of the present disclosure, a size of the first sensor may be different from a size of the second sensor, and a size of the third sensor may be different from a size of the fourth sensor. The term size may refer to an area of the corresponding sensor visible in a plan view.

According to some embodiments of the present disclosure, the voltage measurement device may further include a first fastener and a second fastener that fix the busbar. A distance from the shunt resistance in the first direction to each of the first fastener and the second fastener may be longer than a distance from the shunt resistance in the first direction to each of the first sensor and the second sensor.

According to some embodiments of the present disclosure, the first fastener may be electrically connected to the first terminal, and the second fastener is electrically connected to the second terminal.

According to some embodiments of the present disclosure, the voltage measurement device may further include a first fastener, a second fastener, a third fastener, and a fourth fastener that fix the busbar. The first fastener and the second fastener may be electrically connected to the first terminal, a distance from the shunt resistance in the first direction to each of the first fastener and the second fastener may be longer than a distance from the shunt resistance in the first direction to each of the first sensor and the second sensor, the third fastener and the fourth fastener may be electrically connected to the second terminal, and a distance from the shunt resistance in the first direction to each of the third fastener and the fourth fastener may be longer than a distance from the shunt resistance along the first direction to each of the third sensor and the fourth sensor.

According to some embodiments of the present disclosure, the first fastener, the first sensor, the second sensor, and the second fastener may be positioned along a first straight line in the first direction, and the third fastener, the third sensor, the fourth sensor, and the fourth fastener may be positioned along a second straight line in the first direction.

According to some embodiments of the present disclosure, the shunt resistance may cross opposite sides of the busbar.

According to some embodiments of the present disclosure, the voltage measurement device may further include a control unit configured to calculate a first current value for the first sub-region based on the first voltage value, and calculates a second current value for the second sub-region based on the second voltage value.

According to some embodiments of the present disclosure, the control unit may be configured to output a warning associated with the shunt resistance by comparing a ratio of the first voltage value to the second voltage value with a threshold value.

According to some embodiments of the present disclosure for solving the above technical problem, a voltage measurement device includes a busbar electrically connected to a first terminal and a second terminal that are electrically connected to a battery cell, the busbar extending in a first direction, a shunt resistance positioned on the busbar and extending in a second direction that intersects the first direction, a measurement device configured to measure a first voltage value applied to a first sub-region of the shunt resistance and measures a second voltage value applied to a second sub-region of the shunt resistance, and a boundary portion in a form of a hole formed through the busbar, the boundary portion separating the first sub-region and the second sub-region.

According to some embodiments of the present disclosure, the voltage measurement device may further include a first sensor and a second sensor positioned at opposite ends of the first sub-region, each of the first and second sensors having a measurement terminal disposed thereon for measuring voltages by the measurement device, and a third sensor and a fourth sensor positioned at opposite ends of the second sub-region, each of the third and fourth sensors having a measurement terminal disposed thereon for measuring voltages by the measurement device.

According to some embodiments of the present disclosure, the measurement device may be configured to measure a third voltage value applied between the first sensor and the fourth sensor and a fourth voltage value applied between the third sensor and the second sensor.

According to some embodiments of the present disclosure, the first sensor and the third sensor may be disposed on a first side of the shunt resistance, and the second sensor and the fourth sensor may be disposed on a second side of the shunt resistance that is opposite to the first side of the shunt resistance.

According to some embodiments of the present disclosure, the voltage measurement device may further include a first fastener, a second fastener, a third fastener, and a fourth fastener to fix the busbar. The first fastener and the second fastener may be electrically connected to the first terminal, and a distance from the shunt resistance in the first direction to each of the first fastener and the second fastener may be longer than a distance from the shunt resistance in the first direction to each of the first sensor and the third sensor, and the third fastener and the fourth fastener may be electrically connected to the second terminal, and a distance from the shunt resistance in the first direction to each of the third fastener and the fourth fastener may be longer than a distance from the shunt resistance in the first direction to each of the second sensor and the fourth sensor.

According to some embodiments of the present disclosure, the first fastener, the first sensor, the second sensor, and the third fastener may be positioned along a first straight line in the first direction, and the third fastener, the third sensor, the fourth sensor, and the fourth fastener may be positioned along a second straight line in the first direction.

According to various embodiments of the present disclosure, redundancy in voltage measurement for a shunt resistance can be secured.

According to various embodiments of the present disclosure, a failure that would otherwise occur when the measurement terminals are provided at different positions is prevented, and, thus, costs, manpower, and the like for repairing the failure are not necessary.

According to various embodiments of the present disclosure, a single busbar is disposed in a partial section where a battery cell is connected, and, thus, redundancy of the voltage measurement for this section is secured. Multiple busbars are not needed, which results in the manufacturing cost of the voltage measurement device being reduced.

However, aspects and features of the present disclosure are not limited to those described above, and other aspects and features not mentioned will be clearly understood by a person skilled in the art from the detailed description.

### BRIEF DESCRIPTION OF DRAWINGS

The drawings illustrate embodiments of the present disclosure and describe aspects and features of the present disclosure together with the detailed description below. But the present disclosure should not be construed as being limited to the drawings.
Fig. 1 is a schematic diagram of a voltage measurement device according to an embodiment of the present disclosure;
Fig. 2 is a plan view illustrating a busbar according to an embodiment of the present disclosure;
Fig. 3 is a plan view illustrating a busbar according to another embodiment of the present disclosure;
Fig. 4 illustrates an example of a battery system according to an embodiment of the present disclosure;
Fig. 5 illustrates an example of a busbar according to an embodiment of the present disclosure;
Fig. 6 illustrates an example of a busbar according to an embodiment of the present disclosure;
Fig. 7 illustrates multiple busbars according to a comparative example;
Fig. 8 illustrates a busbar according to an embodiment of the present disclosure;
Fig. 9 is a plan view of multiple busbars according to an embodiment of the present disclosure;
Figs. 10 and 11 illustrate examples of battery packs according to one embodiment of the present disclosure; and
Figs. 12 and 13 illustrate examples of a vehicle body including a battery pack according to an embodiment of the present disclosure and vehicle body components.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an element "above (or below)" or "on (under)" another element may mean that the element may be disposed in contact with the upper (or lower) surface of the element, and another element may also be interposed between the element and the element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

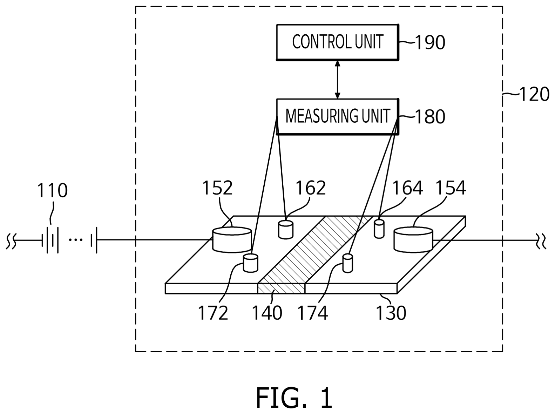

Fig. 1 is a schematic diagram of a voltage measurement device 120 according to an embodiment of the present disclosure. The voltage measurement device 120 may be electrically connected to battery cells 110. In the embodiment depicted in Fig. 1, a plurality of battery cells 110 are provided, but one battery cell may be provided in other embodiments. Further, the connection between a positive terminal and a negative terminal of the battery cell 110 and the voltage measurement device 120 is not limited to what is shown in Fig. 1. For example, directions of the positive terminal and the negative terminal of the battery cell 110 may be opposite to what is shown in Fig. 1.

The voltage measurement device 120 may include a busbar 130 and a shunt resistance 140. The busbar 130 may be electrically connected to a first terminal (for example, a positive terminal) and a second terminal (for example, a negative terminal) of the battery cell 110, and current may thereby flow through the busbar 130. The busbar 130 may extend in a first direction, for example, a direction from a first fastening unit 152 to a second fastening unit 154. The current flowing along the busbar 130 may flow in the first direction. But the direction of the current flowing along the busbar 130 may depend on whether the battery cell 110 is charged or discharged.

The shunt resistance 140 may be positioned on the busbar 130 and may extend in a second direction intersecting the first direction, that is, for example, a direction perpendicular to the first direction. The current flowing through the busbar 130 may pass through the shunt resistance 140. Thus, the shunt resistance 140 may play a role of electrical resistance for a potential difference in the first direction in the busbar 130.

The voltage measurement device 120 may include a measurement unit 180 and a control unit 190. The measurement unit 180 and the control unit 190 may be included in or a part of a battery management system (BMS). The battery management system may be an apparatus for managing the battery cell 110 and may monitor the battery cell 110. The measurement unit 180 and the control unit 190 may communicate with each other to transmit and receive information to and from the voltage measurement device 120. Although embodiments will be described herein in which the measurement unit 180 and the control unit 190 are implemented as separate modules, the present disclosure is not limited thereto as the measurement unit 180 and the control unit 190 may be implemented as one module.

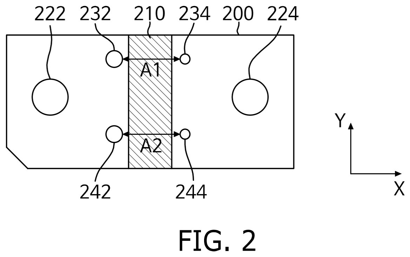

The measurement unit 180 may measure a first voltage value applied to a first sub-region including a part of the shunt resistance 140. The measurement unit 180 may measure a second voltage value applied to a second sub-region including another part of the shunt resistance 140. A first sensing unit 162 and a second sensing unit 164 may be positioned at ends of the first sub-region. A third sensing unit 172 and a fourth sensing unit 174 may be positioned at ends of the second sub-region. The first sensing unit 162 and the second sensing unit 164, and the third sensing unit 172 and the fourth sensing unit 174 may be arranged on opposite sides of the shunt resistance 140, respectively, in the first direction. Measurement terminals providing for voltage measurement by the measurement unit 180 may be disposed in the first sensing unit (sensor) 162, the second sensing unit (sensor)164, the third sensing unit (sensor) 172, and the fourth sensing unit (sensor) 174. Thus, the measurement unit 180 may measure the first voltage value for the first sub-region between the first sensing unit 162 and the second sensing unit 164 and the second voltage value for the second sub-region between the third sensing unit 172 and the fourth sensing unit 174 using the measurement terminals. Specific positions of the first sub-region and the second sub-region will be described in detail below with reference to Fig. 2.

The control unit 190 may determine whether or not there is an error in the shunt resistance 140 based on the first voltage value and the second voltage value. For example, the control unit 190 may determine whether or not there is an error in the shunt resistance 140 by comparing a ratio of the first voltage value to the second voltage value with a threshold value. It may be determined that there is an error in the shunt resistance 140 when said ratio exceeds the threshold.

The control unit 190 may also calculate a first current value for the first sub-region based on the first voltage value and may calculate a second current value for the second sub-region based on the second voltage value. The control unit 190 may determine whether or not there is an error in the shunt resistance 140 by comparing the first current value and the second current value.

The control unit 190 may output a warning associated with the shunt resistance 140 in response to determining that there is an error in the shunt resistance 140. For example, the control unit 190 may output information requesting repair of the shunt resistance 140 or the voltage measurement device 120 to an apparatus or a system connected to the control unit 190. Examples of such connected devices include an energy storage system including the battery cell 110 and/or the voltage measurement device 120, an output apparatus connected wirelessly to a vehicle, and the like.

The voltage measurement device 120 may include the first fastening unit 152 and the second fastening unit 154 for securing the busbar 130. For example, the busbar 130 may be disposed in a structure including the battery cell 110 (e.g., an energy storage system or a vehicle), and may be coupled to the structure using the first fastening unit 152 and the second fastening unit 154. In an embodiment, the first fastening unit 152 may be electrically connected to the first terminal of the battery cell 110, and the second fastening unit 154 may be electrically connected to the second terminal of the battery cell 110. The current may flow through the busbar 130 by way of the first fastening unit 152 and the second fastening unit 154.

As described above, the voltage measurement device 120 may have a plurality of sensing units (sensors) 162, 164, 172, and 174. The multiple units make it possible to measure voltages for a plurality of regions with respect to the shunt resistance 140. And, thus, redundancy of the voltage measurement for the shunt resistance 140 can be secured.

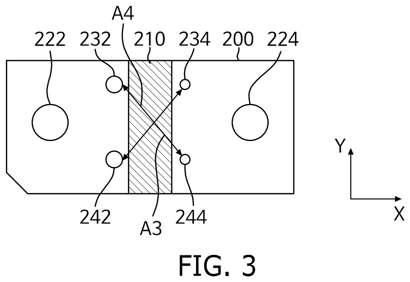

Fig. 2 is a plan view illustrating a busbar 200 according to an embodiment of the present disclosure. Fig. 3 is a plan view illustrating a busbar 200 according to another embodiment of the present disclosure. Referring to Fig. 2, the busbar 200 may be electrically connected to a first terminal (not illustrated) and a second terminal (not illustrated) that are electrically connected to the battery cell. The busbar 200 may extend in a first direction (X-axis). The current flowing due to the electrical connection of the first terminal and the second terminal in the busbar 200 may flow in the first direction (X-axis) or in an opposite direction.

A shunt resistance 210 may be positioned on the busbar 200. In the depicted example, the shunt resistance 210 is positioned in a central region of the busbar 200 with respect to the first direction (X-axis). That is, the shunt resistance 210 may be inserted into the central region of the busbar 200. And in a particular example, the shunt resistance 210 may be inserted into a groove that is formed in the central region of the busbar 200.

The shunt resistance 210 may extend in a direction intersecting the first direction (X-axis). For example, the shunt resistance 210 may extend in a second direction (Y-axis) perpendicular to the first direction (X-axis). A length of the shunt resistance 210 in the second direction may be equal to or substantially equal to a length of the busbar 200 in the second direction.

In one embodiment, a first sensing unit 232 and a third sensing unit 242 may be disposed next to a first side, with respect to the first direction, of the shunt resistance 210 on the busbar 200. A second sensing unit 234 and a fourth sensing unit 244 may be disposed next to a second side of the shunt resistance 210 on the busbar 200. Additionally or alternatively, the first sensing unit 232 may be disposed symmetrically with the second sensing unit 234 with respect to a center line of the shunt resistance 210. And the third sensing unit 242 may be disposed symmetrically with the fourth sensing unit 244 with respect to the center line of the shunt resistance 210. Here, the center line of the shunt resistance 210 refers to an imaginary line that crosses a center of the shunt resistance 210 with respect to the first direction (X-axis) and is parallel to the second direction (Y-axis).

As shown in Fig. 2, a first sub-region A1 may be a region between the first sensing unit 232 and the second sensing unit 234. A second sub-region A2 may be a region between the third sensing unit 242 and the fourth sensing unit 244. The first sub-region A1 and the second sub-region A2 may be arranged in different positions along the second direction (e.g., the Y-axis). A measurement unit (for example, the measurement unit 180 depicted in Fig. 1) may measure a first voltage value applied to the first sub-region A1 and a second voltage value applied to the second sub-region A2.

A first fastening unit (fastener) 222 and a second fastening unit (fastener) 224 may be positioned on the busbar 200 to secure the busbar 200. The first fastening unit 222 may be electrically connected to a first terminal of the battery cell, and the second fastening unit 224 may be electrically connected to a second terminal of the battery cell. The busbar 200 may allow current to flow by a voltage applied between the first fastening unit 222 and the second fastening unit 224.

The first fastening unit 222 may be closer to a first end of the busbar 200 than the first sensing unit 232 and the third sensing unit 242. The second fastening unit 222 may be closer to a second end of the busbar 200 than the second sensing unit 234 and the fourth sensing unit 244. For example, a distance from the shunt resistance 210 along the first direction (X-axis) to each of the first fastening unit 222 and the second fastening unit 224 may be longer than a distance from the shunt resistance 210 along the first direction (X-axis) to each of the first sensing unit 232 and the second sensing unit 234. In an embodiment, the distance from the shunt resistance 210 along the first direction (X-axis) to the first fastening unit 222 and the distance from the shunt resistance 210 along the first direction (X-axis) to the second fastening unit 224 may be substantially equal.

In a specific example, a resistance value of the shunt resistance 210 may be 32 µΩ ± 1.6 µΩ, and a current of about 650 A may be applied between the first fastening unit 222 and the second fastening unit 224. The first voltage value for the first sub-region A1 may be about 20.82 mV, and the second voltage value for the second sub-region A2 may be about 20.86 mV. When a ratio of the first voltage value to the second voltage value (or a difference of said ratio to a reference value)is less than a threshold value, such as 10% or 50%, it may be determined that the shunt resistance 210 and/or the busbar 200 are operating normally.

A size of the first sensing unit 232 may be larger than a size of the second sensing unit 234 , and a size of the third sensing unit 242 may be larger than a size of the fourth sensing unit 244. In such an example, the sizes of the sensing units disposed next to the first side of the shunt resistance 210 and the sensing units disposed next to the second side of the shunt resistance 210 are different. As a result, a user handling the busbar 200 may easily determine the left and right sides of the busbar 200. The sensing units may be designed to be easily visually identifiable by a user.

Each of the first sensing unit 232, the second sensing unit 234, the third sensing unit 242, and the fourth sensing unit 244 may have a measurement terminal for measuring the voltage by the measurement unit. For example, a bolt-shaped measurement terminal may be inserted into each of through-holes of the first sensing unit 232, the second sensing unit 234, the third sensing unit 242, and the fourth sensing unit 244. The size of the measurement terminals may correspond to sizes of the through-holes of the sensing units.

The first sensing unit 232 and the third sensing unit 242 may correspond to first terminals, for example, positive terminals. The second sensing unit 234 and the fourth sensing unit 244 may correspond to second terminals, for example, negative terminals. The measurement terminals associated with the first terminals may be inserted into the first sensing unit 232 and the third sensing unit 242, respectively, and the measurement terminals associated with the second terminals may be inserted into the second sensing unit 234 and the fourth sensing unit 244, respectively. In an embodiment, the sizes of the first sensing unit 232 and the second sensing unit 234 may be different, and the sizes of the third sensing unit 242 and the fourth sensing unit 244 may be different. The different sizes may prevent incorrect insertion of the measurement terminals associated with the first terminals and the measurement terminals associated with the second terminals. When the measurement terminals are inserted at incorrect positions, a failure may occur in the measurement unit or in the battery management system including the measurement unit. But this failure can be prevented in advance, and costs, manpower, and the like for repairing the failure can thereby be avoided.

Referring to Fig. 3, a third sub-region A3 may be a region between the first sensing unit 232 and the fourth sensing unit 244. A fourth sub-region A4 may be a region between the third sensing unit 242 and the second sensing unit 234. The measurement unit may measure a third voltage value applied to the third sub-region A3 and a fourth voltage value applied to the fourth sub-region A4. The third sub-region A3 may overlap the first sub-region A1 and/or the second sub-region A2. The fourth sub-region A4 may overlap the first sub-region A1 and/or the second sub-region A2. The third sub-region A3 may cross the fourth sub-region A4.

In a specific example, a resistance value of the shunt resistance 210 may be 32 µΩ ± 1.6 µΩ, and a current of about 650 A may be applied between the first fastening unit 222 and the second fastening unit 224. The third voltage value for the third sub-region A3 may be about 20.77 mV, and the fourth voltage value for the fourth sub-region A4 may be about 20.81 mV. When a ratio of the third voltage value to the fourth voltage value (or a difference of said ratio to a reference value) is less than a threshold value, such as 10% and 50%, it may be determined that the shunt resistance 210 and/or the busbar 200 are operating normally.

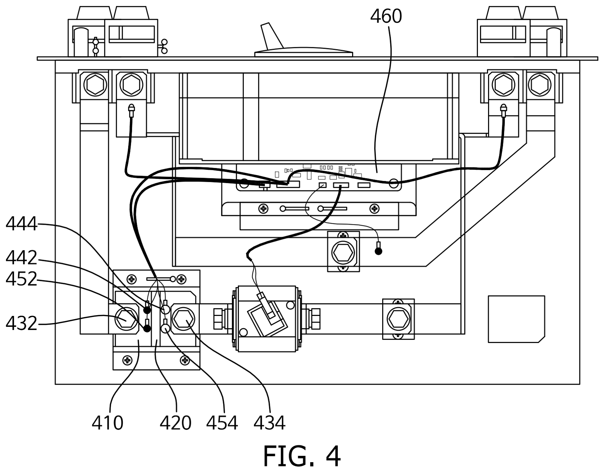

Fig. 4 is an illustration of an example of a battery system according to an embodiment of the present disclosure. The battery system may be an energy storage source that accommodates a plurality of battery cells electrically connected in series and/or parallel. As specific examples, the battery system may be an energy storage system, a battery pack included within a vehicle, and the like.

The battery system may include a voltage measurement device including a first busbar 410, a shunt resistance 420, a measurement unit, and a control unit. The battery system may further include a battery management system that monitors a plurality of battery cells. The battery management system may be implemented through hardware such as components, circuits, and the like included in a printed circuit board 460 and/or software operating on the hardware. The battery management system may include a measurement unit and a control unit, and the measurement unit and the control unit may also be implemented through components, circuits, and the like included in the printed circuit board 460.

The first busbar 410 may be disposed between busbars in the battery system. For example, the first busbar may be disposed between a second busbar that is electrically connected to first terminals of the plurality of battery cells and a third busbar that is electrically connected to second terminals of the plurality of battery cells. The first busbar 410 may be fixed to the second busbar by a first fastening unit 432, and the first busbar 410 may be fixed to the third busbar by a second fastening unit 434. In a particular example, the first busbar 410 may be coupled to the second busbar with the first fastening unit 432 in the form of a bolt or the like that extends through the first and second busbars. Similarly, the first busbar 410 may be coupled to the third busbar with the second fastening unit 434 in the form of a bolt or the like. As such, the first busbar 410 may be electrically connected to the first terminals and the second terminals of the plurality of battery cells.

The shunt resistance 420 may be disposed on the first busbar 410 between the first fastening unit 432 and the second fastening unit 434. Current flowing due to a voltage applied between the first fastening unit 432 and the second fastening unit 434 may flow across the shunt resistance 420.

A first sensing unit 442 and a third sensing unit 452 may be disposed next to a first side of the shunt resistance 420. A second sensing unit 444 and a fourth sensing unit 454 may be disposed next to a second side of the shunt resistance 420. Measurement terminals may be disposed in the first sensing unit 442, the second sensing unit 444, the third sensing unit 452, and the fourth sensing unit 454, and the measurement terminals may be connected to the printed circuit board 460. With such a configuration, the measurement unit in the printed circuit board 460 may measure voltage values for a first sub-region between the first sensing unit 442 and the second sensing unit 444, a second sub-region between the third sensing unit 452 and the fourth sensing unit 454, a third sub-region between the first sensing unit 442 and the fourth sensing unit 454, and/or a fourth sub-region between the second sensing unit 444 and the third sensing unit 452. The voltage values measured in this manner may be transmitted to the control unit, and the control unit may determine whether or not there is an error in the shunt resistance 420 based on the measured voltage values.

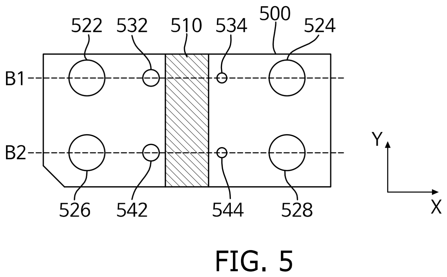

Fig. 5 illustrates an example of a busbar 500 according to an embodiment of the present disclosure. The busbar 500 illustrated in Fig. 5 is the same as the busbar 200 of Fig. 2 except for the fastening units. Thus, descriptions below focus on the fastening units.

A first fastening unit 522, a second fastening unit 524, a third fastening unit 526, and a fourth fastening unit 528 may be provided to fix the busbar 500. The first fastening unit 522 and the third fastening unit 526 may be electrically connected to a first terminal of the battery cell, and the second fastening unit 524 and the fourth fastening unit 528 may be electrically connected to a second terminal of the battery cell. The busbar 200 may allow current to flow by a voltage applied between the first fastening unit 522 and the third fastening unit 526 and between the second fastening unit 524 and the fourth fastening unit 528.

The first fastening unit 522 may be closer to the first end of the busbar 500 than a first sensing unit 532 is to the first end of the busbar 500, and the third fastening unit 526 may be closer to the first end of the busbar 500 than the third sensing unit 542 is to the first end of the busbar 500. The second fastening unit 524 may be closer to the second end of the busbar 500 than a second sensing unit 534 is to the second end of the busbar 500, and the fourth fastening unit 528 may be closer to the second end of the busbar 500 than a fourth sensing unit 544 is to the second end of the busbar 500. As such, a distance from a shunt resistance along a first direction (X-axis) to each of the first fastening unit 522 and the second fastening unit 524 may be longer than a distance from a shunt resistance 510 along the first direction (X-axis) to each of the first sensing unit 532 and the second sensing unit 534, respectively. Moreover, a distance from the shunt resistance along the first direction to each of the third fastening unit 526 and the fourth fastening unit 528 may be longer than a distance from the shunt resistance 510 along the first direction to each of the third sensing unit 542 and the fourth sensing unit 544, respectively.

The first fastening unit 522, the first sensing unit 532, the second sensing unit 534, and the second fastening unit 524 may be disposed along a straight line B1 parallel to the first direction (X-axis direction). In particular, centers of the first fastening unit 522, the first sensing unit 532, the second sensing unit 534, and the second fastening unit 524 may be disposed along the straight line B1. Similarly, the third fastening unit 526, the third sensing unit 542, the fourth sensing unit 544, and the fourth fastening unit 528 may be disposed along a straight line B2 in the first direction (or parallel to the first direction). In particular, centers of the third fastening unit 526, the third sensing unit 542, the fourth sensing unit 544, and the fourth fastening unit 528 may be disposed long the straight line B2. As a result, a voltage of a first sub-region between the first sensing unit 532 and the second sensing unit 534 and a voltage of a second sub-region between the third sensing unit 542 and the fourth sensing unit 544 may be maintained at a substantially equal value.

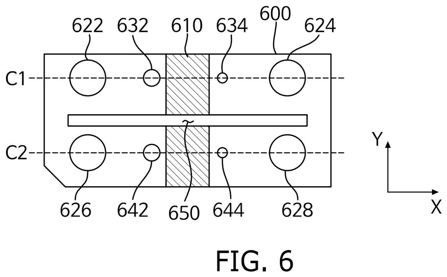

Fig. 6 illustrates an example of a busbar 600 according to an embodiment of the present disclosure. The busbar 600 illustrated in Fig. 6 is the same as the busbar 500 of Fig. 5 except for a boundary portion 650. Descriptions below will therefore focus on the boundary portion 650.

The voltage measurement device may include the boundary portion 650 that is positioned on the busbar 600. The boundary portion 650 may be a through-hole that separates a part of a shunt resistance 610 from another part of the shunt resistance 610. In order for the boundary portion 650 to separate a part of the shunt resistance 610 from another part, a length of the boundary portion 650 in the first (X-axis) direction may be longer than a length of the shunt resistance 610 in the first direction. In other words, the shunt resistance 610 may also be physically divided into two portions by a boundary portion 650 in the form of a through hole.

The boundary portion 650 may cross the shunt resistance 610. For example, the boundary portion 650 may cross a central region of the shunt resistance 610 in a second direction (Y-axis) and extend in the first direction (X-axis). As such, the boundary portion 650 may divide the shunt resistance into a part of the shunt resistance 610 included in a first sub-region between a first sensing unit 632 and a second sensing unit 634 and another part of the shunt resistance 610 included in a second sub-region between a third sensing unit 642 and a fourth sensing unit 644. And the boundary portion 650 may be disposed between a pair of the first sensing unit 632 and the second sensing unit 634 and a pair of the third sensing unit 642 and the fourth sensing unit 644. The boundary portion 650 may be disposed between a straight line C1 along which a first fastening unit 622, the first sensing unit 632, the second sensing unit 634, and a second fastening unit 624 are disposed, and a straight line C2 along which a third fastening unit 626, the third sensing unit 642, the fourth sensing unit 644, and a fourth fastening unit 628 are disposed. The boundary portion 650 may extend in parallel to the straight line C1 and/or the straight line C2.

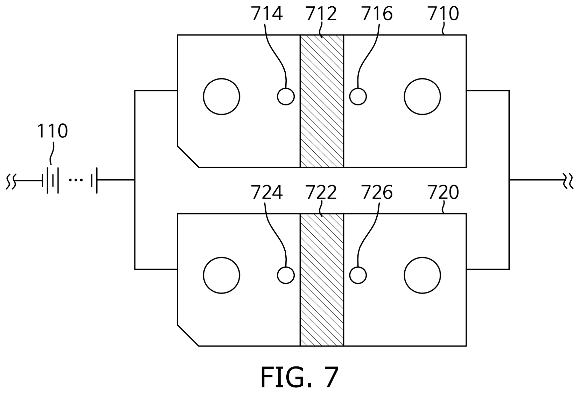

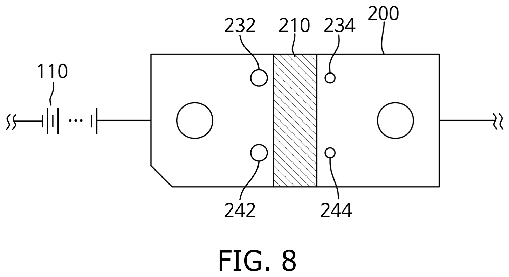

Fig. 7 illustrates a plurality of busbars 710 and 720 according to a comparative example. Fig. 8 illustrates the busbar 200 according to an embodiment of the present disclosure. Referring to Fig. 7, the plurality of busbars 710 and 720 may be electrically connected to battery cells 110. In a comparative example, a pair of sensing units may be disposed on each of the plurality of busbars 710 and 720. For example, a first sensing unit 714 and a second sensing unit 716 may be disposed on both sides of a first shunt resistance 712 disposed on a first busbar 710. A third sensing unit 724 and a fourth sensing unit 726 may be disposed on both sides of a second shunt resistance 722 disposed on a second busbar 720.

A voltage measurement device according to the comparative example may measure a voltage for a partial section where the battery cells 110 are connected through the plurality of busbars 710 and 720. For example, a measurement unit included in the voltage measurement device may measure a voltage value for a region between the first sensing unit 714 and the second sensing unit 716 through measurement terminals disposed in the first sensing unit 714 and the second sensing unit 716. The measurement unit may also measure a voltage value for a region between the third sensing unit 724 and the fourth sensing unit 726 through measurement terminals disposed in the third sensing unit 724 and the fourth sensing unit 726.

Thus, according to the comparative example, the plurality of busbars 710 and 720 are used to provide redundancy of the voltage measurement for a partial section where battery cells 110 are connected.

Fig. 8 shows the busbar 200 and the battery cells 110 connected as described above with reference to Fig. 2. The voltage measurement device according to an embodiment of the present disclosure may measure a voltage for a partial section where the battery cells 110 are connected via the busbar 200. For example, the measurement unit included in the voltage measurement device may measure the first voltage value for the first sub-region between the first sensing unit 232 and the second sensing unit 234. The measurement unit may also measure the second voltage value for the second sub-region between the third sensing unit 242 and the fourth sensing unit 244.

Unlike the comparative example depicted in Fig. 7, a single busbar 200 is disposed in a partial section where the battery cells 110 are connected, and with the configuration of the single busbar 200, redundancy of the voltage measurement for this section can be secured. Instead of disposing multiple busbars, the manufacturing cost of the voltage measurement device is reduced by using the single busbar 200.

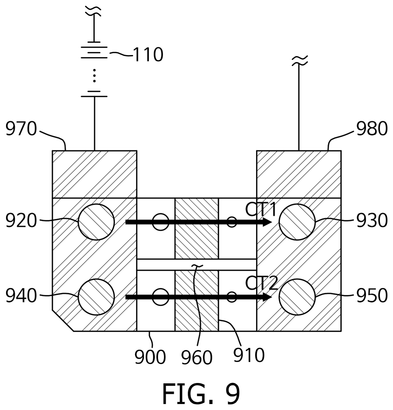

Fig. 9 is a plan view illustrating a plurality of busbars 900, 970, and 980 according to an embodiment of the present disclosure. The first busbar 900 in Fig. 9 is substantially identical to the busbar 600 in Fig. 6.

The first busbar 900 may be connected to a second busbar 970 that is connected to the first terminals of the battery cells 110. In particular, the first busbar may be connected to the second busbar 970 by a first fastening unit 920 and a third fastening unit 940. The first busbar 900 may be connected to a third busbar 980 that is connected to the second terminals of the battery cells 110. In particular, the first busbar 900 may be connected to the third busbar 980 by a second fastening unit 930 and a fourth fastening unit 950. The first busbar 900 may be electrically connected to the first terminal through the second busbar 970 and to the second terminal through the third busbar 980.

A boundary portion 960 may be disposed on the first busbar 900 to separate a part of a shunt resistance 910 from another part of the shunt resistance 910. The boundary portion 960 may divide a part of the shunt resistance 910 included in a first sub-region between the first sensing unit and the second sensing unit and another part of the shunt resistance 910 included in a second sub-region between the third sensing unit and the fourth sensing unit. With the positioning of the boundary portion 960, a resistance value of the shunt resistance 910 between the first fastening unit 920 and the second fastening unit 930 and a resistance value of the shunt resistance 910 between the third fastening unit 940 and the fourth fastening unit 950 may be substantially equal. Thus, a magnitude of a first current CT1 flowing between the first fastening unit 920 and the second fastening unit 930 and a magnitude of a second current CT2 flowing between the third fastening unit 940 and the fourth fastening unit 950 may be substantially equal. But the directions of the first current CT1 and the second current CT2 are not limited to the directions illustrated in Fig. 9, and may be opposite to the direction of the first current CT1 and the direction of the second current CT2 depending on whether or not the battery cell 110 is being charged or discharged.

As described above, redundancy of voltage and/or current measurement can be secured for a single busbar 900 by a pair of the first and second fastening units 920 and 930, a pair of the third and fourth fastening units 940 and 950, and the boundary portion 960.

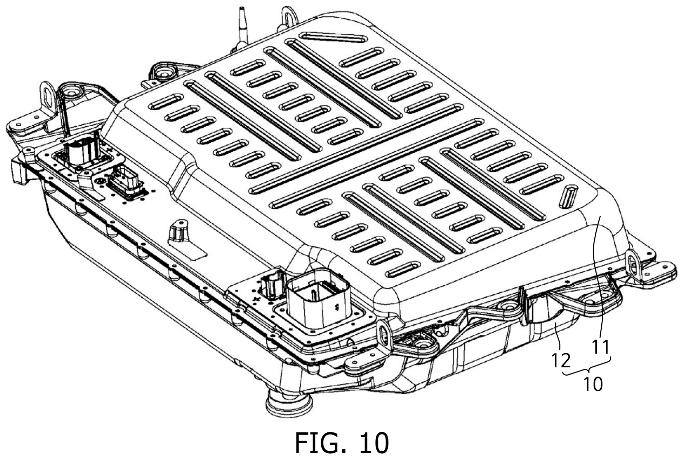

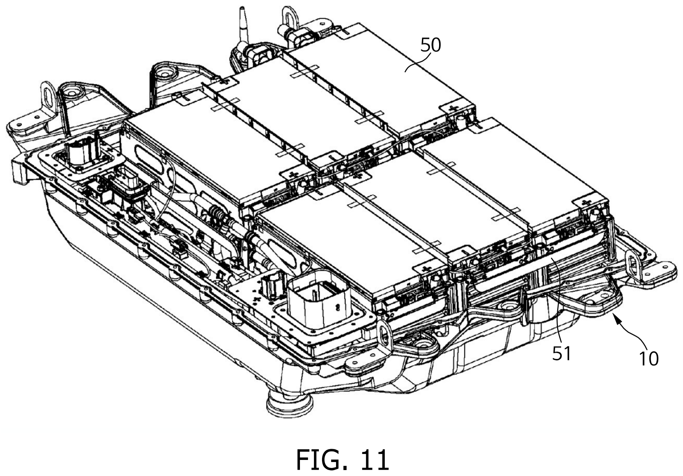

Figs. 10 and 11 are diagrams illustrating examples of a battery pack according to an embodiment of the present disclosure.

The battery pack may include a plurality of battery modules 50 and a housing 10 for accommodating the plurality of battery modules 50. The housing 10 may include first and second housings 11 and 12 coupled and facing each other with the plurality of battery modules 50 interposed therebetween. The plurality of battery modules 50 may be electrically connected to each other by using a connecting portion 51, and the plurality of battery modules 50 may be electrically connected to each other in a series or parallel or series-parallel hybrid manner to obtain a required electrical output.

The battery pack may include the battery module 50 and the voltage measurement device (for example, the voltage measurement device 120 of Fig. 1) for measuring voltages between the plurality of battery modules 50. For example, the battery pack may include the battery modules 50 and the busbar (for example, the busbar 200 of Fig. 2) electrically connecting the plurality of battery modules 50, and may include the measurement unit and the control unit for measuring the voltage value of the shunt resistance disposed on the busbar. The measurement unit and control unit may be included in the battery pack and may be included in the battery management system that monitors the voltages, currents, temperatures, and the like of the battery cells to monitor statuses of the battery cells, and manages the charging and discharging of the batteries.

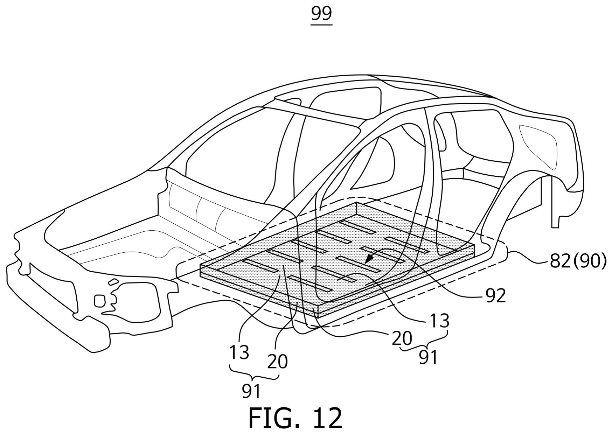

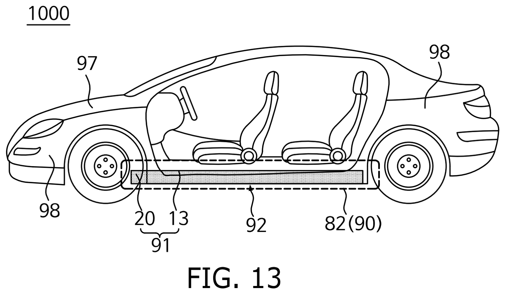

Figs. 12 and 13 illustrate examples of a vehicle body having a battery pack and vehicle body components according to embodiments of the present disclosure.

In Fig. 12, a battery pack 91 may include a battery pack cover 13 that is a part of a vehicle underbody 92 and a pack frame 20 that is disposed at a lower portion of the vehicle underbody 92. The vehicle underbody 92 may separate an interior and an exterior of a vehicle, and the pack frame 20 may be disposed on the exterior of the vehicle. The pack frame 20 and battery pack cover 13 may be formed integrally with a vehicle floor 82. The pack frame 20 may refer to a housing for accommodating battery modules within the battery pack.

Fig. 13 is a schematic side view of a vehicle according to an embodiment of the present disclosure. A vehicle 1000 may be formed by coupling additional components such as a hood 97 at the front of the vehicle and fenders 98 positioned at the front and rear of the vehicle to a vehicle body 99. The vehicle 1000 may further include a vehicle floor 82, which is one of vehicle body components 90, which includes a battery pack 91 including a pack frame 20 and a battery pack cover 13.

Although the present disclosure has been described above with respect to embodiments thereof, the present disclosure is not limited thereto. Various modifications and variations can be made thereto by those skilled in the art within the present disclosure.

### DESCRIPTION OF SOME REFERENCE SYMBOLS

- 110:: battery cell
- 120:: voltage measurement device
- 130:: busbar
- 140:: shunt resistance
- 152:: first fastening unit
- 154:: second fastening unit
- 162:: first sensing unit
- 164:: second sensing unit
- 172:: third sensing unit
- 174:: fourth sensing unit
- 180:: measurement unit
- 190:: control unit

## Claims

1. A voltage measurement device (120) comprising:
a busbar (200) electrically connected to a first terminal and a second terminal that are electrically connected to a battery cell (110), the busbar (200) extending in a first direction;
a shunt resistance (210) positioned on the busbar (200) and extending in a second direction that intersects the first direction; and
a measurement device (180) configured to measure a first voltage value applied to a first sub-region A1 of the shunt resistance (210) and a second voltage value applied to a second sub-region A2 of the shunt resistance (210).

2. The voltage measurement device (120) according to claim 1, further comprising:
a first sensor (232) and a second sensor (234) positioned at opposite ends of the first sub-region A1, each of the first (232) and second (234) sensors having a measurement terminal disposed thereon for measuring voltages by the measurement device (180); and
a third sensor (242) and a fourth sensor (244) positioned at opposite ends of the second sub-region A2, each of the third (242) and fourth (244) sensors having a measurement terminal disposed thereon for measuring voltages by the measurement device (180).

3. The voltage measurement device (120) according to claim 2, wherein the measurement device (180) is configured to measure a third voltage value applied between the first sensor (232) and the fourth sensor (244), and to measure a fourth voltage value applied between the third sensor (242) and the second sensor (234).

4. The voltage measurement device (120) according to claim 2 or claim 3, wherein the first sensor (232) and the third sensor (242) are adjacent to a first side of the shunt resistance (210), and
wherein the second sensor (234) and the fourth sensor (244) are adjacent to a second side of the shunt resistance (210).

5. The voltage measurement device (120) according to one of claims claim 2 to 4, wherein the first sensor (232) is symmetric to the second sensor (234) with respect to a center line of the shunt resistance (210), and
wherein the third sensor (242) is symmetric with respect to the fourth sensor (244) with respect to the center line of the shunt resistance (210).

6. The voltage measurement device (120) according to one of claims 2 to 5, wherein a size of the first sensor (232) is different from a size of the second sensor (234), and
wherein a size of the third sensor (242) is different from a size of the fourth sensor (244).

7. The voltage measurement device (120) according to one of claims 2 to 6, further comprising a first fastener (222) and a second fastener (224) that fix the busbar (200),
wherein a distance from the shunt resistance (210) in the first direction to each of the first fastener (222) and the second fastener (224) is longer than a distance from the shunt resistance (210) in the first direction to each of the first sensor (232) and the second sensor (234).

8. The voltage measurement device (120) according to claim 7, wherein the first fastener (222) is electrically connected to the first terminal, and the second fastener (224) is electrically connected to the second terminal.

9. The voltage measurement device 120 according to one of claims 2 to 8, further comprising a first fastener (522), a second fastener (524), a third fastener (526), and a fourth fastener (528) that fix the busbar (500),
wherein the first fastener (522) and the second fastener (524) are electrically connected to the first terminal,
wherein a distance from the shunt resistance (510) in the first direction to each of the first fastener (522) and the second fastener (524) is longer than a distance from the shunt resistance (510) in the first direction to each of the first sensor (532) and the second sensor (534),
wherein the third fastener (526) and the fourth fastener (528) are electrically connected to the second terminal, and
wherein a distance from the shunt resistance (510) in the first direction to each of the third fastener (526) and the fourth fastener (528) is longer than a distance from the shunt resistance (510) along the first direction to each of the third fastener (526) and the fourth fastener (528).

10. The voltage measurement device (120) according to claim 9, wherein the first fastener (522), the first sensor (532), the second sensor (534), and the second fastener (524) are positioned along a first straight line B1 in the first direction, and
wherein the third fastener (526), the third sensor (542), the fourth sensor (544), and the fourth fastener (528) are positioned along a second straight line B2 in the first direction.

11. The voltage measurement device (120) according to one of the preceding claims, wherein the shunt resistance (210) crosses opposite sides of the busbar (200).

12. The voltage measurement device (120) according to one of the preceding claims, further comprising a control unit (190) configured to calculate a first current value for the first sub-region A1 based on the first voltage value and a second current value for the second sub-region A2 based on the second voltage value.

13. The voltage measurement device (120) according to claim 12, wherein the control unit (190) is configured to output a warning associated with the shunt resistance (140) by comparing a ratio of the first voltage value to the second voltage value with a threshold value.

14. A voltage measurement device (120) comprising:
a busbar (600) electrically connected to a first terminal and a second terminal that are electrically connected to a battery cell (110), the busbar (600) extending in a first direction;
a shunt resistance (610) positioned on the busbar (600) and extending in a second direction that intersects the first direction;
a measurement device (180) configured to measure a first voltage value applied to a first sub-region of the shunt resistance (610) and a second voltage value applied to a second sub-region of the shunt resistance (610); and
a boundary portion (650) in a form of a hole formed through the busbar (600), the boundary portion (650) separating the first sub-region and the second sub-region.

15. The voltage measurement device (120) according to claim 14, further comprising:
a first sensor (632) and a second sensor (634) positioned at opposite ends of the first sub-region, each of the first (632) and second (634) sensors having a measurement terminal disposed thereon for measuring voltages by the measurement device (180); and
a third sensor (642) and a fourth sensor (644) positioned at opposite ends of the second sub-region, each of the third (642) and fourth (644) sensors having a measurement terminal disposed thereon for measuring voltages by the measurement device (180).
